# EUROPEAN PATENT APPLICATION

(11) **EP 4 019 252 A1**
(43) Date of publication of application: **29.06.2022**
(21) Application number: 20216880.3
(22) Date of filing: 23.12.2020
(51) Int. Cl.: B33Y 80/00, H01L 23/427, H05K 7/20, B22F 7/04

(54) **HEAT-TRANSFER DEVICE AND METHOD TO PRODUCE SUCH A DEVICE**

(71) Applicant: ABB Schweiz AG, 5400 Baden (CH)
(72) Inventor: Torresin, Daniele, 5400 Baden (CH); Agostini, Bruno, 8006 Zürich (CH); Petrov, Andrey, 8048 Zürich (CH)
(74) Representative: Qip Patentanwälte Dr. Kuehn & Partner mbB

(57) **Abstract**

A heat-transfer device (100) comprises a bi-porous wick (102) having at least one layer (120) comprising a micro-porous body (122) and tubular macro-pores (124), and a dense casing (104) enclosing the wick (102), wherein the body (122) and the macro-pores (124) are fluidically interconnected and are at least partially overlapping inside the layer (120).

## Description

### FIELD OF THE INVENTION

The invention relates to a heat-transfer device and a method to produce such a device.

### BACKGROUND OF THE INVENTION

A heat-transfer device can be a phase-change device. The heat-transfer device can be a heat-pipe, for example. The heat-transfer device can keep a fluid in a controlled atmosphere. In the controlled atmosphere a phase-change temperature of the fluid is defined. For example, an evaporation temperature of the fluid is defined by the atmosphere. During an evaporation at a warm area of the heat-transfer device, an evaporation energy is absorbed by the fluid while the evaporation temperature is not exceeded. The evaporation energy is transported by the vapor to a colder area of the heat-transfer device below a condensation temperature, where the vapor condenses, and a condensation energy is transferred to the colder area at the condensation temperature. The condensed fluid returns to the warm area and the evaporation begins anew.

A wick inside the heat-transfer device facilitates the return of the condensed fluid. The wick can be made of a fibrous wicking material, for example.

### DESCRIPTION OF THE INVENTION

It is an objective of the invention to provide an improved heat-transfer device. This objective is achieved by the subject-matter of the independent claim. Further exemplary embodiments are evident from the dependent claims and the following description.

The invention relates to a heat-transfer device, comprising a bi-porous wick having at least one layer comprising a micro-porous body and tubular macro-pores, and a dense casing enclosing the wick, wherein the body and the macro-pores are fluidically interconnected and are at least partially overlapping inside the layer.

A heat-transfer device may use two consecutive phase changes of a fluid enclosed in the heat-transfer device to transfer thermal energy through the device. A first phase change may be an evaporation of the fluid from liquid to vapor. A second phase change may be a condensation of the fluid from vapor to liquid.

A heat source may define a warm side of the heat-transfer device. The heat source may be thermally connected to the warm side. The heat source may supply the thermal energy. A heat sink may define a cold side of the heat-transfer device. The heat sink may be thermally connected to the cold side. The heat sink may absorb the thermal energy. The heat source may be a microprocessor, for example. The heat sink may be a heat dissipator, for example.

The vaporization takes place at the warm side. Ideally, the thermal energy from the heat source is isothermally absorbed by the enthalpy of the vaporization and leads to the first phase change from liquid to vapor. The vapor transports the thermal energy through the heat-transfer device to the cold side.

The condensation of the vapor takes place at the cold side. Ideally, the enthalpy of the condensation is isothermally released to the heat sink and leads to the second phase change from vapor back to liquid. The liquid moves back through the heat-transfer device to the warm side.

The movement of the different phases of the liquid is driven by a concentration gradient inside the heat-transfer device. The vapor is produced at the warm side and disappears at the cold side. The liquid is produced at the cold side and disappears at the warm side.

A wick facilitates the movement of the liquid back to the warm side by capillary forces. The capillary forces may overcome gravity to a certain extent. The capillary forces may be caused by the fluid being attracted to pores in the wick. A bi-porous wick may have two differently sized pore size ranges.

A micro-porous body may consist of interconnected grains with interconnected micro-pores in between the grains. The micro-pores may be referred to as very small capillaries. The capillary forces in the micro-pores may be very high. A capillary length in the micro-pores may approximately reach the maximum capillary length of the liquid.

Tubular macro-pores may resemble channels or small pipes. The macro-pores are in a different size range than the micro-pores. The macro-pores may be referred to as capillaries. The capillary forces inside the macro-pores may be lower than in the micro-pores. The macro-pores may have a lower flow resistance than the micro-pores. The liquid inside the macro-pores may move towards the warm side faster than in the micro-pores.

The liquid may be sucked into the micro-pores where the condensation happens, change over to the macro-pores and be transported to the warm side inside the macro-pores.

In an embodiment, the macro-pores are arranged in the body. The macro-pores may extend through at least part of the body. Surfaces of the macro-pores may be made out of micro-porous material. The liquid may be pumped through the micro-porous body into the macro-pores by the capillary forces. The pumping may advance the movement of the liquid inside the macro-pores.

In an embodiment, the heat-transfer device comprises at least one evaporator area inside the casing and at least one condenser area inside the casing. The macro-pores may fluidically interconnect the condenser area with the evaporator area. An evaporator area may be arranged at the warm side. The evaporator area may have evaporator structures to facilitate the absorption of the thermal energy by the fluid. The evaporator structures may also facilitate a removal of the vapor from the evaporator area. A condenser area may be arranged at the cold side. The condenser area may have condensation structures to facilitate the release of the thermal energy to the heat sink. The macro-pores may be continuous from the condenser area to the evaporator area.

In an embodiment, the body has a pore size between 10 µm and 75 µm. Particularly the body may have a pore size between 20 µm and 60 µm. The pore size may average 40 µm. In this range, the micro-pores may facilitate pumping of the liquid into the macro-pores.

In an embodiment, the macro-pores have a diameter between 0.3 mm and 0.1 mm. In this range, the macro-pores may reach a balance between the capillary length and the flow resistance.

In an embodiment, the wick comprises differently sized macro-pores arranged in different layers of the wick. There may be a gradient in the pore size from layer to layer. There may also be a gradient in the pore size inside one layer. Different sized pores may have differing flow resistance. If the amount of liquid in the wick raises, the liquid can flow faster through bigger pores. That way fluctuations in the thermal energy can be absorbed without a danger of running out of liquid at the warm side.

In an embodiment, the wick comprises differently oriented macro-pores. The macro-pores may be oriented towards the warm side. The macro-pores may be oriented towards multiple hotspots. The macro-pores in one layer may be oriented towards the warm side from different points of the heat-transfer device. The macro-pores of different layers may also be arranged transverse to each other.

In an embodiment, the differently oriented macro-pores are fluidically interconnected. The macro-pores of consecutive layers may be differently oriented. The differently oriented macro-pores may form a macro-pore-mesh inside the body. The mesh may be a reservoir for the liquid. Spare liquid may be stored inside the macro-pores.

In an embodiment, the wick is selectively sintered from loose metal powder grains by additive manufacturing. Metal powder grains have a good heat conductivity. The grains may be made out of a metal material. The grains may be sintered together. The metal material may be a copper material or an aluminum material for example. The metal material may be an alloy. The wick may be sintered according to a CAD model. The wick may be shaped irregularly. The wick may be shaped three-dimensionally to optimize a pumping capability of the micro-porous body and to optimize flow resistance in the macro-pores.

In an embodiment, the wick is connected to the casing and the casing is sintered integrally with the wick. The casing may be produced at the same time as the wick. By integrally connecting the casing and the wick, an optimum thermal connection is reached between the casing and the wick. The casing may be three-dimensionally optimized to connect the heat source and the heat sink.

The invention further relates to a method to produce the heat-transfer device with wick and integral casing, the method comprising:
steering an energy beam targeted at a surface of a feedstock of loose metal powder grains over an expanse of the wick to heat near-surface grains forming the wick to a sintering temperature of the metal and fuse the heated grains to the micro-porous body of the wick, wherein an energy exposure of the grains forming the body is limited to a sintering energy density and the grains in the macro-pores of the wick are circumnavigated by the energy beam, and
steering the energy beam over an expanse of the casing to heat the near-surface grains forming the casing to a melting temperature of the metal and melt the grains to the casing, wherein the energy exposure of the grains forming the casing equates at least a melting energy density.

A feedstock may be a bed of metal powder grains. The bed may have a flat surface. The feedstock may contain excess material. Unused material of the feedstock may be reusable.

An energy beam may be an electron beam or a laser beam for example. The energy beam may be pointed at the surface. The energy beam may narrow towards the surface. The energy beam may hit the surface in a spot. In particular, the energy beam may be oriented approximately perpendicular to the surface. The energy beam may be steered across the surface in two dimensions. There may also be multiple energy beams targeted at the surface.

A temperature of the grains may be raised by absorbing energy from the energy beam and by heat conduction from heated grains to adjoining colder grains. Grains at the surface may be heated directly by the beam. Grains under the surface may be heated by the beam and/or the heat conduction.

A sintering temperature may be below a melting temperature. The sintering temperature may be dependent on the feedstock material. For a copper material the sintering temperature may be between 700°C and 1070°C, for an aluminum material the sintering temperature may be between 400°C and 660°C. At the sintering temperature the grains may be still solid. At the sintering temperature contacting surfaces of the grains may interact on an atomic level and fuse together. Fused particles may be still discernible as individual grains. The fused or sintered grains may have grown together at their contact points.

A sintering energy density may be between 2 J/mm³ and 15 J/mm³. In that range the grains may only reach the sintering temperature. The energy density may be raised slowly to facilitate spreading the energy evenly.

A melting energy density may be between 30 J/mm³ and 70 J/mm³. The melting temperature of a copper material may be between 900°C and 2500°C. The melting temperature of an aluminum material may be between 500°C and 2400°C.

The heat-transfer device may be defined by a CAD model. The device may be three-dimensional. The CAD model may be sliced into two-dimensional layers. In each layer the device may have a cross-section area defined by the CAD model. An expanse of the device may be equivalent to the cross-section area. The expanse may be defined by borders of the cross-section area. The layers of micro-porous body may be embedded in loose feedstock material during the production process. The loose feedstock grains in the macro-pores are removed after the grains forming the body have fused after the sinter process.

In an embodiment, after the sinter process, the wick is moisturized with the fluid, and an atmosphere inside the casing is adjusted to set a phase-change temperature of the fluid. In particular, a pressure inside the casing is reduced below a normal pressure, to lower the evaporation temperature of the liquid fluid below an evaporation temperature at standard atmosphere. That way, the warm side may be kept below a temperature predetermined by the atmosphere inside the casing, as long as there is liquid fluid at the warm side.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawing.
Fig. 1 schematically shows a heat-transfer device according to an embodiment;
Fig. 2 shows a wick of a heat-transfer device according to an embodiment; and
Fig. 3 shows a flow diagram for a method for producing the heat-transfer device of Fig. 1 according to an embodiment of the invention.

The reference symbols used in the drawing, and their meanings, are listed in summary form in the list of reference symbols. In principle, identical parts are provided with the same reference symbols in the figure.

### DETAILED DESCRIPTION OF EXEMPLARY EMBODIMENTS

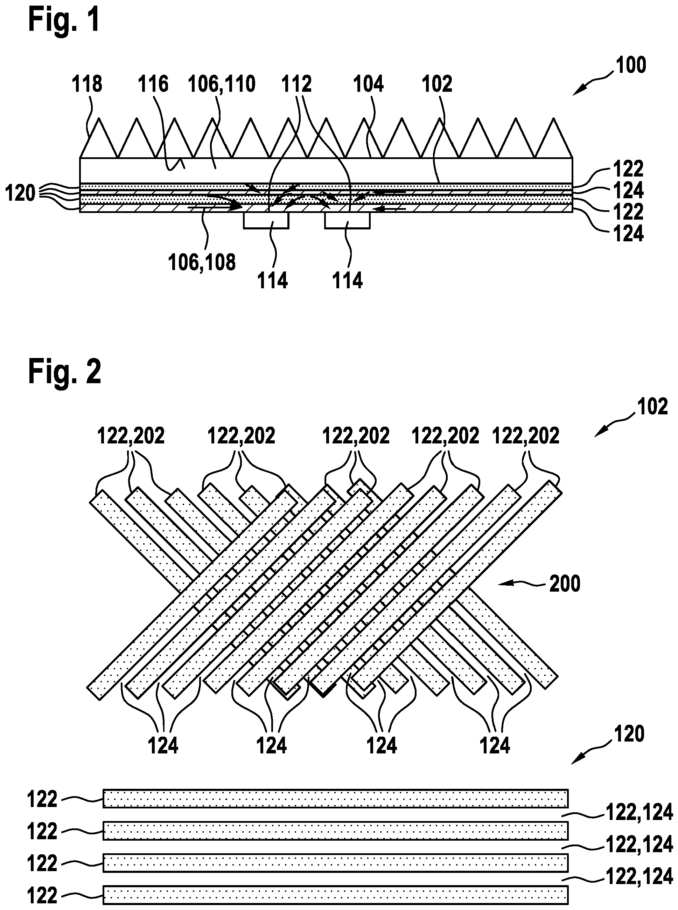

Fig. 1 schematically shows a heat-transfer device 100 according to an embodiment. The heat-transfer device 100 is a phase-change heat-transfer device 100. The heat-transfer device 100 has a bi-porous wick 102 enclosed in a fluid-proof casing 104. The wick 102 is moistened by a fluid 106 in a liquid 108 shape. A space inside the casing 104 over the wick 102 is filled with the fluid 106 in a vapor 110 shape. The liquid 108 evaporates at a warm side 112 of the heat-transfer device 100, where at least one heat source 114 is in contact with the heat-transfer device 100. The vapor 110 condenses at a cold side 116 of the heat-transfer device 100, where a heat sink 118 is in contact with the heat-transfer device 100.

The device 100 is first evacuated and the partially filled with the fluid 106. Because of the vacuum the fluid 106 is in saturation conditions, where a certain fraction of the fluid 106 is liquid 108 and a remaining volume is occupied by the vapor 110 phase of the same fluid 106. The resulting underpressure is set by the temperature of the fluid 106 inside the device 100. During filling operation the temperature is basically the ambient temperature. Then during working conditions, the internal fluid pressure and temperatures increase due to the heat applied on the warm side.

An evaporation temperature of the fluid 106 is set by the underpressure inside the casing. The underpressure also determines a condensation temperature of the fluid 106. The evaporation temperature and the condensation temperature are essentially equal. This way a thermal energy from the heat sources 114 is transported to the heat sink 118 at the evaporation temperature, as long as there is liquid 108 fluid 106 available at the warm side 112.

The wick 102 has layers 120 consisting of a micro-porous body 122 and tubular macro-pores 124. The micro-porous body 122 is in fluidical contact with the macro-pores 124. The liquid 108 in the micro-pores of the micro-porous body 122 reaches a high capillary pressure. The macro-pores 124 have a high permeability for the liquid 108. The micro-pores result in a strong capillary pumping of the liquid 108 towards the macro-pores 124, where the liquid 108 meets a low flow resistance due to the high permeability. The liquid 108 is capillary attracted to the micro-pores after condensation at the cold side 116, gets sucked into the macro-pores 124 and flows through the macro-pores 124 towards the warm side 112.

Fig. 2 shows wicks 102 of a heat-transfer devices 100 according to embodiments. The wicks 102 essentially correspond to the wick in Fig. 1. The wicks 102 have micro-porous bodies 122 and tubular macro-pores 124 interspersed in the bodies 122. The wicks 102 are produced in layers by additive manufacturing. The wicks 102 is sintered from a feedstock of metal powder grains by selectively heating predefined areas of layer after layer to a sintering temperature, which is below a melting temperature of the grains. The grains in the macro-pores 124 remain unsintered and are removed after the sintering process.

In an embodiment, the wick 102 is shaped as a three-dimensional mesh 200 of interconnected macro-pores 124 and interconnected pillars 202 of micro-porous body 122. The macro-pores 124 and the pillars 202 are arranged in multiple tiers. In one tier, parallel macro-pores 124 and pillars 202 are alternating. In the next tier, the alternating macro-pores 124 and pillars 202 are oriented transverse to the macro-pores 124 and pillars 202 of the first tier. The pillars 202 of the tiers are connected at crossing points.

In an alternative embodiment, the wick 102 is shaped as alternating tiers of body 122 without macro-pores 124 and tiers of body 122 with parallel macro-pores 124. Here the macro-pores 124 are not interconnected, as there is always micro-porous body 122 material between the macro-pores 124.

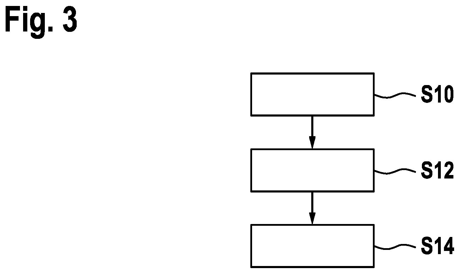

Fig. 3 shows a flow diagram for a method for producing the heat-transfer device 100 such as shown in Fig. 1.

In step S10, near-surface loose metal powder grains forming a wick 102 of the heat-transfer device 100 are heated to a sintering temperature of the metal by steering an energy beam targeted at a surface of a feedstock of the grains over an expanse of the wick 102. An energy exposure of the grains forming the micro-porous body 122 of the wick 102 is limited to a sintering energy density. the heated grains fuse to the body 122. The grains in macro-pores 124 of the wick 102 are circumnavigated by the energy beam.

In step S12, near-surface grains forming a casing 104 of the heat-transfer device 100 are heated to a melting temperature of the metal by steering the energy beam over an expanse of the casing 104. The energy exposure of the grains forming the casing 104 equates at least a melting energy density. The heated grains melt to the casing 104.

In step S14, the heat-transfer device 100 is removed from the feedstock of loose metal powder grains and unused loose metal powder grains are removed from the heat-transfer device 100.

In other words, a multidimensional bi-porous evaporator wick with a novel design of a capillary structure for a vapor chamber and/or a loop heat pipe is presented. With this approach, the boiling heat transfer performance is improved by combining high permeability (fast moving of the fluid) and small pore size (high pumping power) areas with a multidimensional wick structure. This design enables the stacking of alternating different layers with high permeability and high pumping areas on top of each other with different designs, resulting in higher heat flux densities cooling capacities.

Extreme heat dissipation requirements can cause devices to exceed reliable operating temperatures. Simultaneous demands in both packaging and form factor necessitate aggressive heat spreaders. Vapor chambers are promising two-phase, passive cooling solutions demonstrate much higher effective thermal conductivities than traditional solid heat spreaders. Vapor chamber wick materials with small pore sizes have demonstrated advantages such as high capillary pressures, minimal thermal conduction resistances and increased effective heat transfer areas. The low permeability of these materials, however, prevents their usage as the sole wicking material across large length scales.

A hybrid or bi-porous wick can resolve these tradeoffs by utilizing combinations of different porous materials and pore sizes to achieve simultaneous optimization of multiple wick performance parameters, like high permeability structures located above the hotspot and high capillary pressure used to feed fluid to low permeability.

Conventional hybrid or bi-porous wicks may be fabricated by combining copper fibers for high permeability and sintered copper powder for high capillary pumping functions. The high permeability fibers can be located in correspondence with the hot spots and can be surrounded by the powder structure which works as a fluid feeder. The conventional bi-porous wick may be made by a sintering process in a furnace at high temperatures (950 °C) for several hours (10h). In each sintering process, only one single layer can be produced. A thickness of the sintered powder layer and a thickness of the fiber layer can be different, but to achieve a multidimensional bi-porous wick structure, this process would have to be repeated for each single layer. For this reason, a conventional multidimensional bi-porous wick is only feasible for a single layer wick structure.

The presented solution consists of a multidimensional bi-porous wick for evaporators of vapor chambers and/or loop heat pipes. In an embodiment, the wick has at least one bi-porous wick single layer with at least one small pore size region (preferably in the range between 80 and 5 um) for capillary pressure and at least one more region with high permeability for feeding the fluid to the low permeability region.

In an embodiment, these two regions overlap each other and are in communication, i.e., the fluid can flow from one to another region.

In an embodiment, the high permeability region is made out of small hydraulic diameter channels (typically 0.1-0.3 mm).

In an embodiment, the high capillary pressure region is made by sintered powder, preferably with the diameter in the 10-120 µm range, which yields an effective pore diameter between 5 µm and 80 µm.

In an embodiment, multiple bi-porous layers are stacked on top of each other to create a multidimensional bi-porous wick. The layers in the stack can have different pore size and hydraulic channel diameters.

In an embodiment, each layer of wick structure is stacked on top of the one below with an angle in terms of fluid flow direction in the high permeability channels.

In an embodiment, the direction of the high permeability channels within a single layer varies in order to better guide the fluid flow to the hot spot.

In an embodiment, the evaporator wick structure is made in one process by using additive manufacturing.

In an embodiment, multiple bi-porous layers are stacked on top of each other to create a multidimensional wick as an evaporator of a vapor chamber and/or a loop heat pipe. Each bi-porous layer is made by at least one area with small pores size (preferably in the range between 50 and 20 um) for capillary pressure and at least one area with high permeability for feeding the fluid to the hot spot areas. These layers are stacked on top of each other and are in communication thermally and fluidically.

The high permeability is created by small hydraulic diameter channels. A size of the channels can be tuned based on the working fluid properties, in particular, a dynamic viscosity and a density of the working fluid.

The geometry and layout of the bi-porous layers can be tuned based on application, hot spot locations and cooling requirements. Usually, pillars in the vapor chamber have a solid core and are surrounded by a wick structure to provide the fluid return form the condenser. If channels with high permeability are in contact with the porous body around the pillars and are oriented towards the hot spot locations, they can provide feeding of liquid which can delay a drying out.

One of the advantages of a multilayer bi-porous wick compared to a conventional single bi-porous layer is the increased amount of fluid which can be brought toward the hot spot areas. This results in higher thermal performance due to a delay of the dry-out.

This geometry allows also working in unfavorable conditions where the evaporator is located higher than the condenser (against the gravity). In fact, with the multidimensional bi-porous wick, the capillary pressure layers enable the feeding of the high permeability areas under the hotspots even when the fluid has to return to the evaporator against the gravity.

Additive manufacturing technology enables the multilayer bi-porous wick to have a customized design depending on the application.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practicing the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 100: heat-transfer device
- 102: wick
- 104: casing
- 106: fluid
- 108: liquid
- 110: vapor
- 112: warm side
- 114: heat source
- 116: cold side
- 118: heat sink
- 120: layer
- 122: micro-porous body
- 124: macro-pores

- 200: mesh
- 202: pillar

## Claims

1. A heat-transfer device (100), comprising:
a bi-porous wick (102) having at least one layer (120) comprising a micro-porous body (122) and tubular macro-pores (124), and
a dense casing (104) enclosing the wick (102),
wherein the body (122) and the macro-pores (124) are fluidically interconnected and are at least partially overlapping inside the layer (120).

2. The heat-transfer device (100) of claim 1,
wherein the macro-pores (124) are arranged in the body (122).

3. The heat-transfer device (100) of one of the previous claims, comprising at least one evaporator area inside the casing (104) and at least one condenser area inside the casing (104),
wherein the bi-porous wick (102) fluidically interconnects the condenser area with the evaporator area.

4. The heat-transfer device (100) of one of the previous claims,
wherein the body (122) has a pore size between 80 µm and 5 µm.

5. The heat-transfer device (100) of one of the previous claims,
wherein the macro-pores (124) have a diameter between 0.3 mm and 0.1 mm.

6. The heat-transfer device (100) of one of the previous claims,
wherein the wick (102) comprises differently sized macro-pores (124) arranged in different layers (120) of the wick (102).

7. The heat-transfer device (100) of one of the previous claims,
wherein the wick (102) comprises differently oriented macro-pores (124).

8. The heat-transfer device (100) of claim 7,
wherein the differently oriented macro-pores (124) are fluidically interconnected.

9. The heat-transfer device (100) of one of the previous claims,
wherein the wick (102) is selectively sintered from loose metal powder grains by additive manufacturing.

10. The heat-transfer device (100) of claims 8 and 9,
wherein the wick (102) is connected to the casing (104) and the casing (104) is sintered integrally with the wick (102).

11. A method to produce the heat-transfer device (100) of claim 10, the method comprising:
steering an energy beam targeted at a surface of a feedstock of loose metal powder grains over an expanse of a wick (102) of the heat-transfer device (100) to heat near-surface grains forming the wick (102) to a sintering temperature of the metal and fuse the heated grains to a micro-porous body (122) of the wick (102), wherein an energy exposure of the grains forming the body (122) is limited to a sintering energy density and the grains in macro-pores (124) of the wick (102) are circumnavigated by the energy beam, and steering the energy beam over an expanse of a casing (104) of the heat-transfer device (100) to heat the near-surface grains forming the casing (104) to a melting temperature of the metal and melt the grains to the casing (104), wherein the energy exposure of the grains forming the casing (104) equates at least a melting energy density.

12. The method of claim 11,
wherein the grains in the macro-pores (124) are removed after the grains forming the body (122) have fused.

13. The method one of the claims 11 to 12,
wherein the wick (102) is moisturized with a fluid (106), and an atmosphere inside the casing (104) is adjusted to set a phase-change temperature of the fluid (106).
